# EUROPEAN PATENT APPLICATION

(11) **EP 1 384 701 A1**
(43) Date of publication of application: **28.01.2004**
(21) Application number: 02255170.9
(22) Date of filing: 24.07.2002
(51) Int. Cl.: C03C 17/10, C03C 17/40, C03B 27/00

(54) **Manufacturing method for tempered glass circuit board**

(71) Applicant: Shang Chuen Weighting Machine Co., Ltd., Taichung City (TW)
(72) Inventor: Lee, Wu-Hsiung, Taichung City, Taiwan (TW)
(74) Representative: Alexander, Thomas Bruce

(57) **Abstract**

Manufacturing method for tempered glass circuit board, including steps of: by means of a halftone, evenly painting a layer of silver paste onto the surface of a glass and waiting until the silver paste dries; thereafter, gradually increasing temperature of the glass from 30°C; when the temperature reaches 450∼550°C, thermally fully fusing the surface of the glass with the silver paste; continuously increasing the temperature to 750 ± 2%°C to temper the glass; and thereafter, gradually decreasing the temperature to room temperature to achieve a tempered glass circuit board. A circuit can be directly soldered on the surface of the tempered glass instead of any conductive tempered glass.

## Description

### BACKGROUND OF THE INVENTION

The present invention is related to a manufacturing method for tempered glass circuit board. By means of a halftone, a layer of silver plasma is first painted onto the surface of a glass. Then the glass with the silver plasma is heated to fuse the glass with the silver plasma to form a tempered glass circuit board. The circuit board is then electroplated to avoid oxidation of the silver plasma. A circuit can be directly soldered on the surface of the tempered glass instead of any conductive tempered glass. The tempered glass circuit board is weatherproof and has prolonged using life and good insulation effect.

Conventionally, in order to make a glass conductive, mostly a soft circuit board is adhered to the surface of the glass or a conductive circuit is washed into the coarser capillary of a PC board. The soft circuit board is adhered to the surface of the glass by an adhesive. After a period of time, the soft circuit board tends to detach from the glass. This leads to poor conductivity. Therefore, the circuit board has short using life and needs to be frequently replaced. This will result in problem in environmental protection. Moreover, it is necessary to manually adhere the soft circuit board onto the surface of the glass so that the cost is higher. The existent commercially available PC board is made of fiber material. This also causes problem of environmental protection. In addition, the surfaces of the soft circuit board and the PC board are formed with ribs or protuberances and tend to be scraped. This will lead to poor insulation effect.

### SUMMARY OF THE INVENTION

It is therefore a primary object of the present invention to provide a manufacturing method for tempered glass circuit board. By means of a halftone, a layer of silver plasma is first painted onto the surface of a glass. Then the glass with the silver plasma is heated to fuse the glass with the silver plasma to form a tempered glass circuit board. The tempered glass circuit board is substitutable for soft circuit board and PC board to meet the requirement for environmental protection.

It is a further object of the present invention to provide the above manufacturing method for tempered glass circuit board which is weatherproof. A circuit can be directly soldered on the surface of the tempered glass to increase convenience in use.

It is still a further object of the present invention to provide the above manufacturing method for tempered glass circuit board which is widely applicable to any tempered glass demanding electric conductivity. In addition, the tempered glass circuit board is free from any adhered soft circuit board so that the manufacturing cost is lowered.

It is still a further object of the present invention to provide the above manufacturing method for tempered glass circuit board in which the silver plasma is directly fused with the surface of the glass so that the tempered glass circuit board is not easy to be scraped and has better insulation effect.

It is still a further object of the present invention to provide the above manufacturing method for tempered glass circuit board in which the tempered glass circuit board is electroplated to avoid oxidation and rusting of the silver plasma. Therefore, the tempered glass circuit board is prevented from aging and has prolonged using life.

The present invention can be best understood through the following description and accompanying drawings wherein:

### BRIEF DESCRIPTION OF THE DRAWING

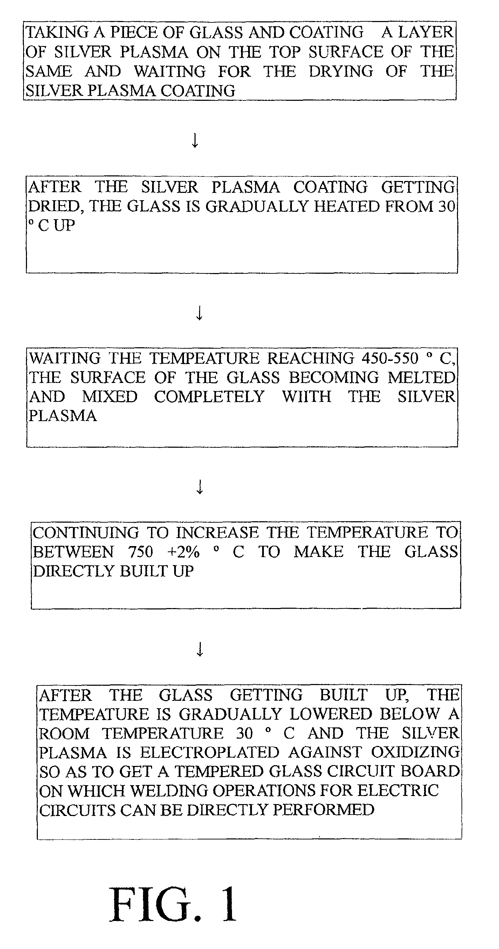

Fig. 1 is a block flow chart of the manufacturing method of the present invention.

### DETAILED DESCRIPTION OF THE PREFERRED EMBODIMENT

Please refer to Fig. 1 which shows a flow chart of the manufacturing method of the present invention. The manufacturing method for tempered glass circuit board of the present invention includes steps of:
A. by means of a halftone, painting a layer of silver plasma onto the surface of a glass, the silver plasma containing 70 ± 2% or 80 ± 2% mixture of silver powder and aluminum alloy, 1-3% glass powder, 3-5% resin and 14-19% organic solvent, the silver plasma having a viscosity within 400 ± 50P, the glass being placed in 150°C for ten minutes to wait until the silver plasma dries;
B. after the silver plasma dries, transferring the glass into a sintering tunnel furnace and gradually increasing temperature from 30°C;
C. when the temperature reaches 450∼550 °C, thermally fully fusing the surface of the glass with the silver plasma;
D. continuously increasing the temperature to 750 ± 2% °C to directly temper the glass; and
E. after the glass is tempered, gradually decreasing the temperature and placing the glass in room temperature of 30 °C, then the glass being electroplated to avoid oxidation to achieve an anti-oxidation and rustproof tempered glass circuit board, whereby a circuit can be directly soldered on the surface of the tempered glass, the tempered glass being applicable to any tempered glass demanding electric conductivity instead of any other tempered glass, for example, the tempered glass being applicable to a sensing area of the step board of a fat weighing scale or a rear window of a car for electrically defogging the rear window.

The above embodiment is only used to illustrate the present invention, not intended to limit the scope thereof. Many modifications of the above embodiment can be made without departing from the spirit of the present invention.

## Claims

1. Manufacturing method for tempered glass circuit board, comprising steps of:
(1) by means of a halftone, painting a layer of silver plasma onto the surface of a glass and waiting until the silver plasma dries, the silver plasma containing silver, mixture of silver powder and aluminum alloy, glass powder, resin and organic solvent;
(2) after the silver plasma dries, transferring the glass into a sintering tunnel furnace and gradually increasing temperature from 30 °C;
(3) when the temperature reaches 450∼550 °C, thermally fully fusing the surface of the glass with the silver plasma;
(4) continuously increasing the temperature to 750 ± 2% °C to directly temper the glass; and
(5) after the glass is tempered, gradually decreasing the temperature and placing the glass in room temperature of 30 °C, then the glass being electroplated to avoid oxidation to achieve an anti-oxidation and rustproof tempered glass circuit board, whereby a circuit can be directly soldered on the surface of the tempered glass, the tempered glass being applicable to any tempered glass demanding electric conductivity instead of any other tempered glass, for example, the tempered glass being applicable to a sensing area of the step board and positive and negative circuits of a fat weighing scale or a rear window of a car for electrically defogging the rear window.

2. Manufacturing method for tempered glass circuit board as claimed in claim 1, wherein the silver plasma contains 70 ± 2% or 80 ± 2% mixture of silver powder and aluminum alloy, 1-3% glass powder, 3-5% resin and 14-19% organic solvent, the silver plasma having a viscosity within 400 ± 50P.

3. Manufacturing method for tempered glass circuit board as claimed in claim 1, wherein the glass painted with the silver plasma is placed in 150°C for ten minutes to wait until the silver plasma dries.

4. Manufacturing method for tempered glass circuit board as claimed in claim 1, wherein the tempered glass circuit board is substitutable for PC board and soft circuit board.
